# EUROPEAN PATENT APPLICATION

(11) **EP 3 187 883 A1**
(43) Date of publication of application: **05.07.2017**
(21) Application number: 15836606.2
(22) Date of filing: 05.08.2015
(51) Int. Cl.: G01R 1/073, G01R 31/26, H01L 21/66

(54) **INSPECTION TERMINAL UNIT, PROBE CARD AND METHOD FOR MANUFACTURING INSPECTION TERMINAL UNIT**

(30) Priority: 29.08.2014 JP 2014176563
(71) Applicant: Omron Corporation, Kyoto-shi, Kyoto 600-8530 (JP)
(72) Inventor: TERANISHI, Hirotada, Kyoto-shi, Kyoto 600-8530 (JP); SAKAI, Takahiro, Kyoto-shi, Kyoto 600-8530 (JP); OZAKI, Hideaki, Kyoto-shi, Kyoto 600-8530 (JP)
(74) Representative: Kilian Kilian & Partner
(86) International application number: PCT/JP2015/072170
(87) International publication number: WO 2016/031512

(57) **Abstract**

An inspection terminal unit includes at least two inspection pins (20), which are arrayed side by side, each of which has a contact portion at a first end of the inspection pin and a connection portion (25) at a second end of the inspection pin, the contact portion being in contact with an inspection object element and the connection portion being connected to a substrate (3), and a holding unit (30) that integrally holds at least the two inspection pins (20).

## Description

### TECHNICAL FIELD

The present invention relates to an inspection terminal unit, a probe card provided with the inspection terminal unit, and a method for manufacturing the inspection terminal unit.

### BACKGROUND ART

For example, PTL 1 discloses an inspection terminal unit. The conventional inspection terminal unit of PTL 1, which is manufactured on a sacrifice substrate, includes plural spring touching elements mounted on a terminal of an electronic component located on the sacrifice substrate.

### CITATION LIST

### PATENT LITERATURE

PTL 1: JP 2008-46139 A

### SUMMARY OF INVENTION

### TECHNICAL PROBLEM

However, in the conventional inspection terminal unit, positioning accuracy of the spring touching element varies because the spring touching elements are fixed onto the sacrifice substrate by a method such as brazing, welding, and soldering. A skill of a worker is required in addition to time and effort in order that the inspection terminal unit is assembled while the positioning accuracy of the spring touching element is maintained, which results in low productivity.

An object of the present invention is to provide a high-productivity inspection terminal unit having the high positioning accuracy of the inspection pin.

### SOLUTION TO PROBLEM

According to one aspect of the present invention, an inspection terminal unit includes: at least two inspection pins arrayed side by side each of which has a contact portion at a first end of the inspection pin and a connection portion at a second end of the inspection pin, the contact portion being in contact with an inspection object element and the connection portion being connected to a substrate; and a holding unit that integrally holds at least the two inspection pins

According to another aspect of the present invention, a probe card includes the inspection terminal unit.

According to still another aspect of the present invention, an inspection terminal unit manufacturing method includes: forming at least two inspection pins by electroforming with a positional relationship, in which the inspection pins are arrayed at any pitch while separating from each other; and integrally holding the inspection pins by using an insulating holding unit while the positional relationship is maintained.

### ADVANTAGEOUS EFFECTS OF INVENTION

In the inspection terminal unit of the present invention, at least the two inspection pins arrayed side by side are integrally held by the holding unit. Therefore, the plural inspection pins can integrally be disposed on the substrate, and the inspection pins can be positioned with high accuracy. Resultantly, the inspection terminal unit can easily be assembled to enhance the productivity of the inspection terminal unit.

The present invention can provide the probe card including the high-productivity inspection terminal unit having the high positioning accuracy of the inspection pin.

In the inspection terminal unit manufacturing method of the present invention, the high-productivity inspection terminal unit can be manufactured with the high positioning accuracy of the inspection pin.

### BRIEF DESCRIPTION OF DRAWINGS

Fig. 1 is a perspective view illustrating a state in which an inspection terminal unit according to a first embodiment of the present invention is fitted on a substrate of a probe card.
Fig. 2 is a plan view illustrating the inspection terminal unit in Fig. 1.
Fig. 3 is an enlarged perspective view illustrating an end portion on a narrow portion side of the inspection terminal unit in Fig. 1.
Figs. 4A and 4B are respectively sectional views schematically illustrating a method for manufacturing the inspection terminal unit in Fig. 1.
Fig. 5 is a schematic diagram illustrating a modification of the end portion on the narrow portion side of the inspection terminal unit in Fig. 1.
Fig. 6 is a schematic diagram illustrating another modification of the end portion on a wide portion side of the inspection terminal unit in Fig. 1.
Fig. 7 is a schematic diagram illustrating a first modification of the end portion on the wide portion side of the inspection terminal unit in Fig. 1.
Fig. 8 is a schematic diagram illustrating a second modification of the end portion on the wide portion side of the inspection terminal unit in Fig. 1.
Fig. 9 is a schematic diagram illustrating a third modification of the end portion on the wide portion side of the inspection terminal unit in Fig. 1.
Fig. 10 is a schematic diagram illustrating a fourth modification of the end portion on the wide portion side of the inspection terminal unit in Fig. 1.
Fig. 11 is a schematic diagram illustrating a fifth modification of the end portion on the wide portion side of the inspection terminal unit in Fig. 1.
Fig. 12 is a schematic diagram illustrating a sixth modification of the end portion on the wide portion side of the inspection terminal unit in Fig. 1.
Figs. 13A, 13B, and 13C are respectively views illustrating an inspection terminal unit according to a second embodiment of the present invention, and Fig. 13A is a perspective view of the inspection terminal unit, Fig. 13B is a font view of the inspection terminal unit, and Fig. 13C is a plan view of the inspection terminal unit.
Figs. 14A, 14B, and 14C are respectively views illustrating an inspection terminal unit according to a third embodiment of the present invention, and Fig. 14A is a perspective view of the inspection terminal unit, Fig. 14B is a font view of the inspection terminal unit, and Fig. 14C is a plan view of the inspection terminal unit.
Figs. 15A, 15B, and 15C are respectively views illustrating an inspection terminal unit according to a fourth embodiment of the present invention, and Fig. 15A is a perspective view of the inspection terminal unit, Fig. 15B is a font view of the inspection terminal unit, and Fig. 15C is a plan view of the inspection terminal unit.
Figs. 16A, 16B, and 16C are respectively views illustrating an inspection terminal unit according to a fifth embodiment of the present invention, and Fig. 16A is a perspective view of the inspection terminal unit, Fig. 16B is a font view of the inspection terminal unit, and Fig. 16C is a plan view of the inspection terminal unit.
Fig. 17 is a plan view schematically illustrating a probe card according to a sixth embodiment of the present invention.
Fig. 18 is a plan view schematically illustrating a probe card according to a seventh embodiment of the present invention.

### DESCRIPTION OF EMBODIMENTS

### (First embodiment)

### [Configuration]

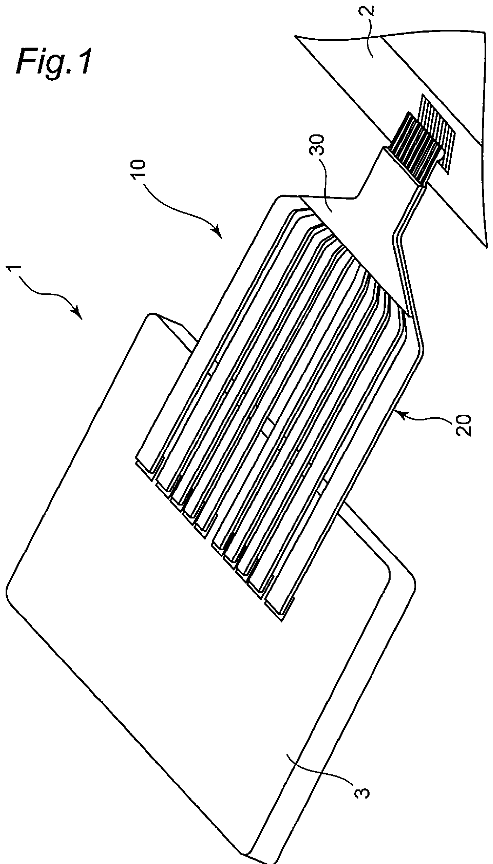

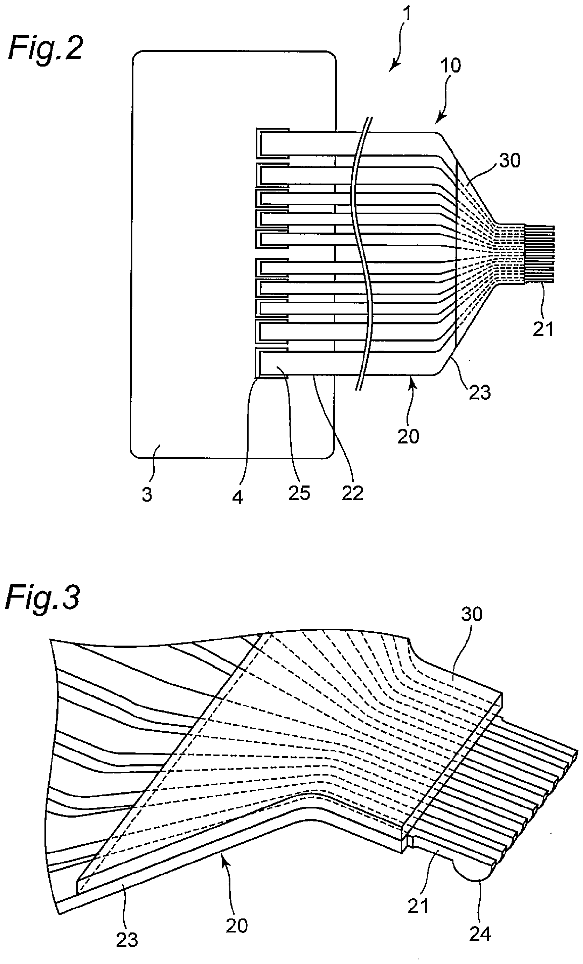

Fig. 1 is a perspective view illustrating a state in which an inspection terminal unit 10 according to a first embodiment of the present invention is mounted on a substrate 3 of a probe card 1. Fig. 2 is a plan view of the inspection terminal unit 10 in Fig. 1, and Fig. 3 is an enlarged perspective view illustrating an end portion on a narrow portion side of the inspection terminal unit 10 in Fig. 1.

As illustrated in Figs. 1 to 3, the inspection terminal unit 10 of the first embodiment includes plural inspection pins 20 and a holding unit 30 holding the inspection pins 20. Each of the inspection pins 20 is formed by electroforming, and the inspection pins 20 are arrayed at a predetermined pitch while being kept separated so as not to be in contact with each other.

As illustrated in Figs. 1 and 2, the inspection pin 20 includes a narrow portion 21, a wide portion 22, and an intermediate portion 23 continuously connected to the narrow portion 21 and wide portion 22. The narrow portion 21, the wide portion 22, and the intermediate portion 23 are integrally formed. The narrow portion 21 and the wide portion 22 extend in the same direction while being parallel to each other.

The narrow portion 21 is formed with a size corresponding to a width of an electrode of an inspection object element 2. The narrow portion 21 includes a contact 24 that is an example of the contact portion projected from a free end (first end) of the narrow portion 21. As illustrated in Fig. 3, the contact 24 has an arc shape in the extending direction of the inspection pin 20, and is configured to touch the electrode of the inspection object element 2.

The wide portion 22 is formed with a size corresponding to a width of a connection object 4 of the substrate 3. The wide portion 22 includes a connection portion 25 connected to the connection object 4 of the substrate 3 at a free end (second end) of the wide portion 22.

The holding unit 30 is made of an insulating material, and disposed so as to partially cover one side of surfaces of the narrow portion 21 and intermediate portion 23 as illustrated in Fig. 3. The holding unit 30 enables the inspection pins 20 to be integrally arrayed at predetermined intervals.

In the inspection terminal unit 10, the inspection pins 20 are disposed such that an interval between the narrow portions 21 adjacent to each other is kept constant, and such that an interval between the wide portions 22 adjacent to each other is larger than the interval between the narrow portions 21. For example, a pitch (interval) between the narrow portions 21 adjacent to each other is 0.1 mm, and a pitch between the wide portions 22 adjacent to each other is 0.5 mm.

### [Manufacturing method]

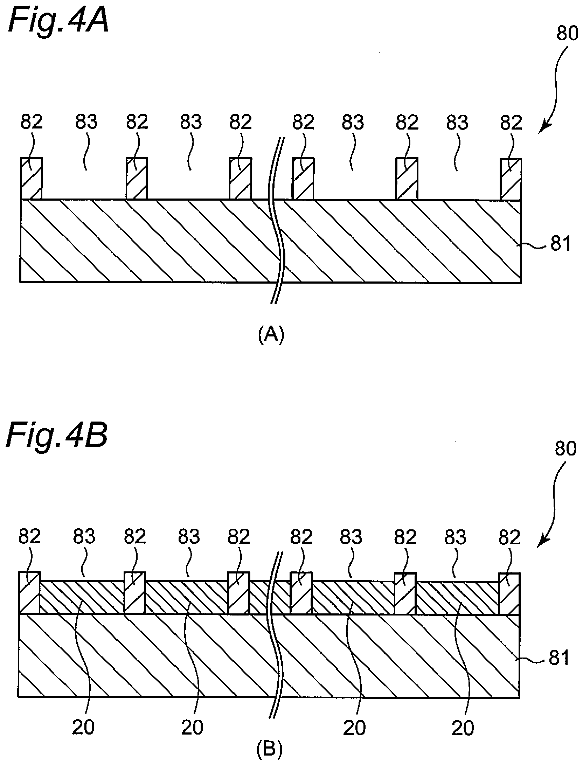

Figs. 4A and 4B are sectional views schematically illustrating a method for manufacturing the inspection terminal unit in Fig. 1.

The method for manufacturing the inspection terminal unit 10 of the first embodiment will be described below with reference to Figs. 4A and 4B.

Plural cavities 83 are formed in a master block 80. The master block 80 includes a conductive plate 81 and an insulating member 82 provided on the conductive plate 81, and the cavities 83 pierce the insulating member 82 to reach the conductive plate 81. The cavities 83 have the same shapes as the inspection pins 20 of the inspection terminal unit 10, and are arrayed side by side at predetermined intervals without being in contact with each other.

Then, the master block 80 is dipped in an electrolytic solution of an electrolytic bath. An electrode (counter electrode) is disposed so as to face the conductive plate 81, and voltage is applied between the conductive plate 81 and the counter electrode. Therefore, metal in the electrolytic solution is electrodeposited on the conductive plate 81 exposed from the cavity 83.

When the voltage is continuously applied between the conductive plate 81 and the counter electrode, the metal is laminated on the conductive plate 81 toward a voltage applying direction. The voltage application is stopped when a metallic layer reaches a predetermined position, namely, when the desired inspection pin 20 is formed.

Then, the insulating member 82 disposed around the formed inspection pin 20 is removed, and an insulating film made of the same material as the insulating member 82 is formed so as to cover an entire top surface (a surface that is not in contact with the conductive plate 81) of the inspection pin 20. Then, an unnecessary portion of the insulating film is removed to form the holding unit 30, and the manufacturing of the inspection terminal unit 10 is completed.

In the inspection terminal unit 10, at least two inspection pins 20 are arrayed side by side and integrally held by the holding unit 30. Therefore, the inspection pins 20 can integrally be disposed in the substrate 3 of the probe card 1, and the inspection pin 20 can be positioned with high accuracy. Resultantly, the inspection terminal unit can easily be assembled to enhance productivity of the inspection terminal unit 10.

The high-productivity inspection terminal unit 10 having the high positioning accuracy of the inspection pin can easily be obtained by electroforming.

### [Modifications]

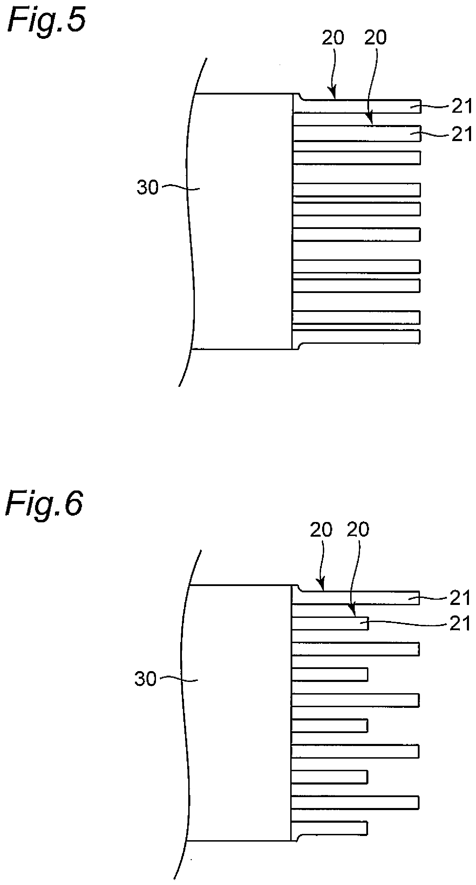

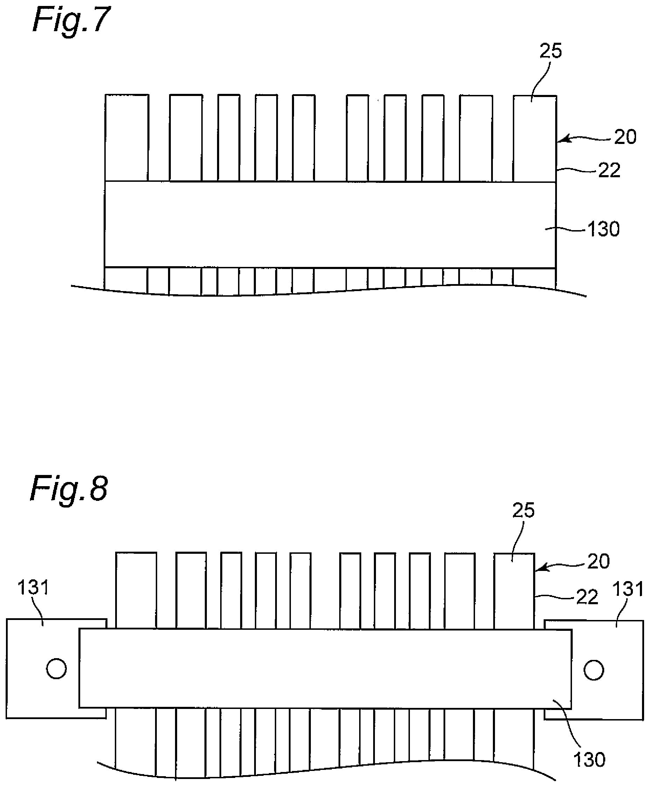

Figs. 5 and 6 are schematic diagrams illustrating modifications of the end portion on the side of the narrow portion 21 of the inspection terminal unit 10 in Fig. 1. Figs. 7 to 12 are schematic diagrams illustrating modifications of the end portion on the side of the wide portion 22 of the inspection terminal unit 10 in Fig. 1.

In the inspection terminal unit 10, all the narrow portions 21 are disposed at equal intervals. Alternatively, for example, as illustrated in Fig. 5, the narrow portions 21 may be disposed at a random pitch such that an interval between the narrow portions 21 varies. Therefore, a degree of designing freedom for the inspection terminal unit 10 is enhanced, and the inspection terminal unit 10 can deal with various inspection object elements.

In the inspection terminal unit 10, the inspection pins 20 are provided such that leading ends on the sides of the narrow portions 21 are located on the same straight line. Alternatively, for example, as illustrated in Fig. 6, the inspection pins 20 may be provided such that the leading ends on the sides of the narrow portions 21 meander in planar view. Therefore, a degree of designing freedom for the inspection terminal unit 10 is enhanced, and the inspection terminal unit 10 can deal with various inspection object elements.

In the inspection terminal unit 10, the contact 24 is provided as the contact portion with respect to all the inspection pins 20. Alternatively, for example, a contact having a different size may be provided in each inspection pin 20, or the contacts are not provided at all.

In short, The end portion on the side of the narrow portion 21 of the inspection terminal unit 10 may have any shape and disposition according to the design of the inspection terminal unit 10 as long as the end portion on the side of the narrow portion 21 of the inspection terminal unit 10 is in contact with the electrode of the inspection object element.

On the other hand, as illustrated in Fig. 7, a holding unit 130 which covers the wide portions 22 of the inspection pins 20 may be provided. When the holding unit 130 is provided, the inspection pins 20 can surely be integrated while maintaining a positional relationship in which the inspection pins 20 are arrayed at any pitch without being in contact with each other, and thus dimensional accuracy of the inspection terminal unit 10 can be improved.

As illustrated in Fig. 8, both ends in a longitudinal direction of the holding unit 130 are positioned in and fixed to positioning portions 131 provided on the substrate 3 of the probe card 1, whereby the inspection terminal unit 10 maybe positioned. This enables the improvement of the positioning accuracy of the inspection terminal unit 10.

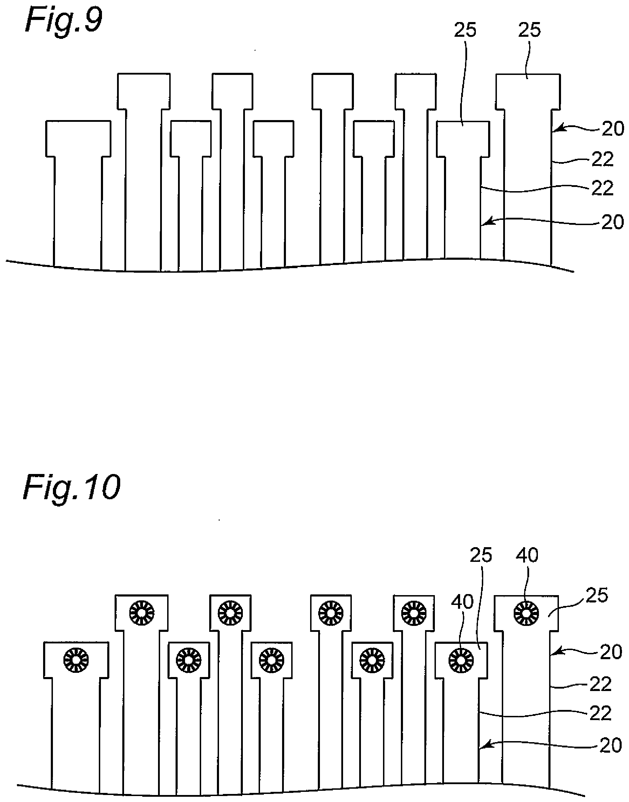

As illustrated in Fig. 9, the inspection pin 20 may be provided such that a leading end on the side of the wide portion 22 of the inspection terminal unit 10 meanders. Therefore, the degree of designing freedom for the inspection terminal unit 10 is enhanced, and the inspection terminal unit 10 can deal with substrates of various probe cards. The meandering of the leading end on the side of the wide portion 22 can increase a size of the connection portion 25. This enables the inspection terminal unit 10 to be easily connected to the substrate 3 of the probe card 1 in Fig. 2.

As illustrated in Fig. 10, a hole 40 may be provided in each of the connection portions 25 of the inspection pins 20. For example, a projection corresponding to the hole 40 is provided in the connection object 4 of the substrate 3 of the probe card 1 in Fig. 2, and the projection is fitted in the hole 40, whereby the inspection terminal unit 10 may be fixed to the substrate 3. This enables the improvement of the positioning accuracy of the inspection terminal unit 10.

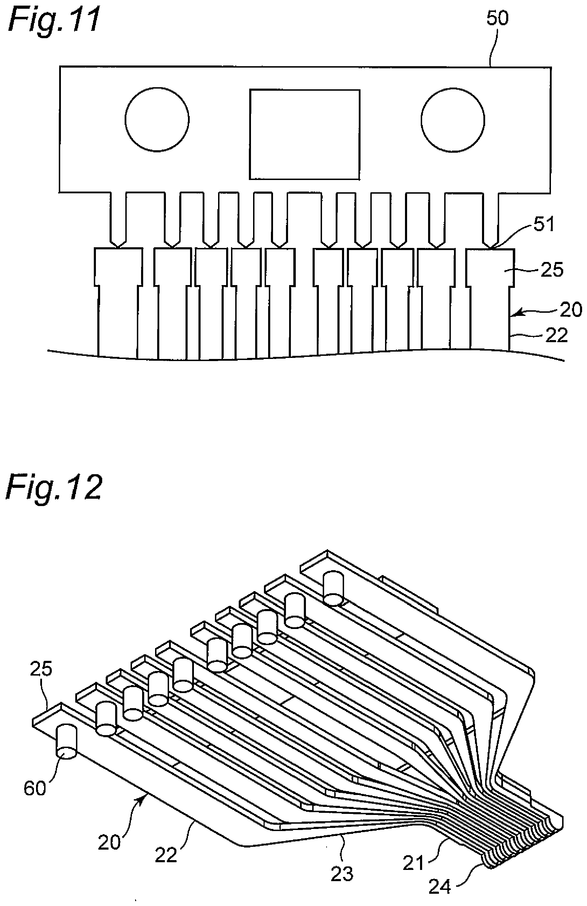

As illustrated in Fig. 11, a conveying carrier 50 may be formed integrally with the inspection pins 20 at the leading ends on the side of the wide portions 22 of the inspection pins 20. The carrier 50 includes narrow breaking portions 51 between the carrier 50 and the wide portions 22, and the inspection terminal unit 10 can be separated from the carrier 50 by breaking the breaking portions 51. When the carrier 50 is provided, the inspection pins 20 can easily be integrated with high positioning accuracy while maintaining the positional relationship in which the inspection pins 20 are arrayed at any pitch without being in contact with each other, and the inspection terminal unit 10 can be positioned on the substrate 3. Therefore, in the inspection terminal unit 10, generation of a manufacturing error can be prevented, and the positioning accuracy can be enhanced.

As illustrated in Fig. 12, a projection 60 having a columnar shape may be formed in the connection portion 25 of the inspection pin 20. For example, a hole (not illustrated) corresponding to the projection 60 is provided in the connection object 4 of the substrate 3 of the probe card 1 in Fig. 2, and the projection 60 is fitted in the hole, whereby the inspection terminal unit 10 may be fitted to the substrate 3. This enables the improvement of the positioning accuracy of the inspection terminal unit 10.

The end portion on the side of the wide portion 22 of the inspection terminal unit 10 may have any shape and disposition according to the design of the inspection terminal unit 10 as long as the end portion on the side of the wide portion 22 of the inspection terminal unit 10 is connected to the connection object 4 provided in the substrate 3 of the probe card 1.

It is necessary for the inspection terminal unit 10 to include at least two inspection pins 20, the inspection terminal unit 10 may include two or more inspect pins according to the design thereof.

The method for forming the inspection pins 20 is not limited to the electroforming, but any method may be adopted if possible.

It is necessary for the holding unit 30 to hold all the inspection pins 20 to be able to fix the inspection pin 20. The holding unit 30 is not limited to the planar shape partially covering the narrow portion 21 and intermediate portion 23 in Figs. 1 to 3. For example, the shape of the holding unit can properly be changed according to a material used in the holding unit, the number of inspection pins, or the size of the inspection pin.

### (Second embodiment)

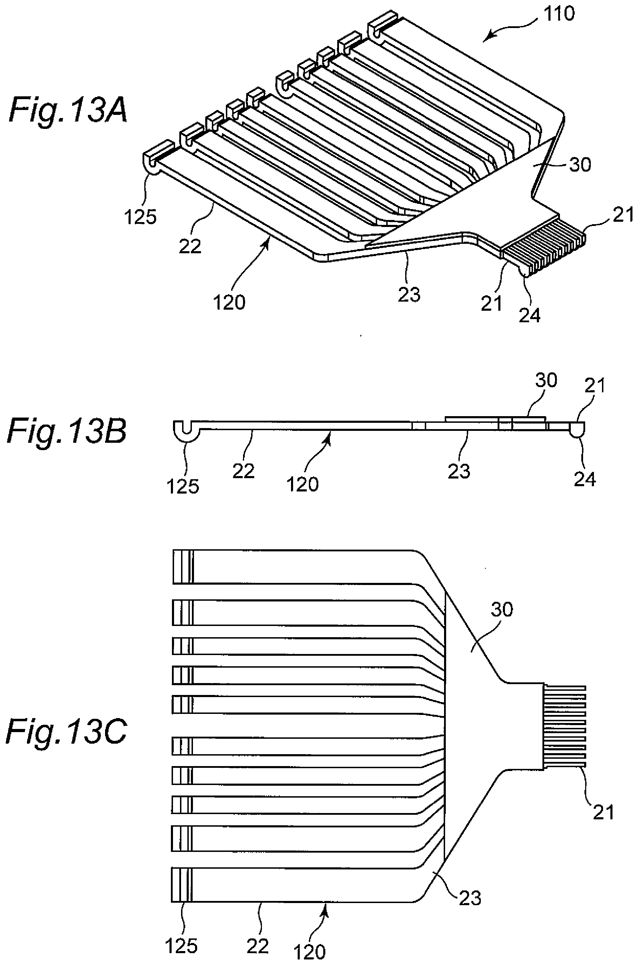

Figs. 13A, 13B, and 13C are respectively views illustrating an inspection terminal unit 110 according to a second embodiment of the present invention, and Fig. 13A is a perspective view of the inspection terminal unit 110, Fig. 13B is a font view of the inspection terminal unit 110, and Fig. 13C is a plan view of the inspection terminal unit 110.

In the inspection terminal unit 110 of the second embodiment, plural inspection pins 120 each of which includes a connection portion 125 are integrated using the holding unit 30. As illustrated in Fig. 13B, the connection portion 125 has a substantial U-shape in section.

The inspection pin 120 has a configuration substantially similar to the inspection pin 20 of the first embodiment except for the connection portion 125. For this reason, the same component as that of the first embodiment is designated by the same reference sign, and the description is omitted.

### (Third embodiment)

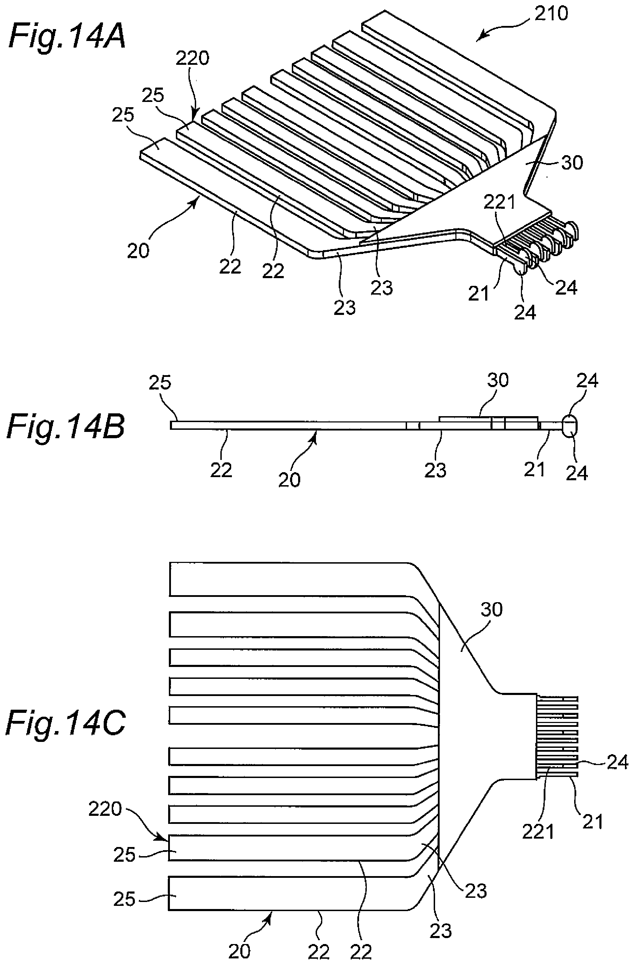

Figs. 14A, 14B, and 14C are respectively views illustrating an inspection terminal unit 210 according to a third embodiment of the present invention, and Fig. 14A is a perspective view of the inspection terminal unit 210, Fig. 14B is a font view of the inspection terminal unit 210, and Fig. 14C is a plan view of the inspection terminal unit 210.

In the inspection terminal unit 210 of the third embodiment, the inspection pins 20 of the first embodiment including the narrow portions 21 and inspection pins 220 including narrow portions 221 are alternately disposed, and integrated using the holding unit 30. Each of the narrow portions 21 of the inspection pins 20 has the contact 24 projected downward (toward the lower side in Fig. 14B), and each of the narrow portions 221 of the inspection pins 220 has the contact 24 projected upward (toward the upper side in Fig. 14B).

The inspection pin 220 has a configuration substantially similar to the inspection pin 20 of the first embodiment except for the narrow portion 221. For this reason, the same component as that of the first embodiment is designated by the same reference sign, and the description is omitted.

### (Fourth embodiment)

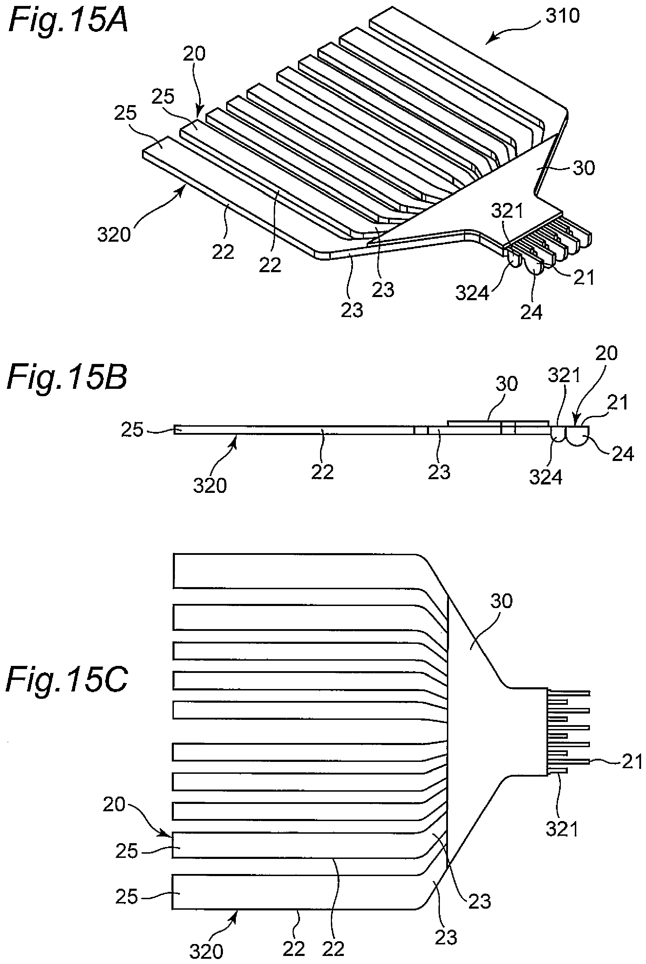

Figs. 15A, 15B, and 15C are respectively views illustrating an inspection terminal unit 310 according to a fourth embodiment of the present invention, and Fig. 15A is a perspective view of the inspection terminal unit 310, Fig. 15B is a font view of the inspection terminal unit 310, and Fig. 15C is a plan view of the inspection terminal unit 310.

In the inspection terminal unit 310 of the fourth embodiment, the inspection pins 20 of the first embodiment and inspection pins 320 including narrow portions 321 shorter than the inspection pins 20 of the first embodiment are integrated using the holding unit 30. In the inspection terminal unit 310, the inspection pins 20 and 320 are alternately disposed such that the end portion on the side of the narrow portion 321 meanders. As illustrated in Fig. 15B, a contact 324 of the narrow portion 321 is formed smaller than the contact 24 of the narrow portion 21.

The inspection pin 320 has a configuration substantially similar to the inspection pin 20 of the first embodiment except for the narrow portion 321. For this reason, the same component as that of the first embodiment is designated by the same reference sign, and the description is omitted.

### (Fifth embodiment)

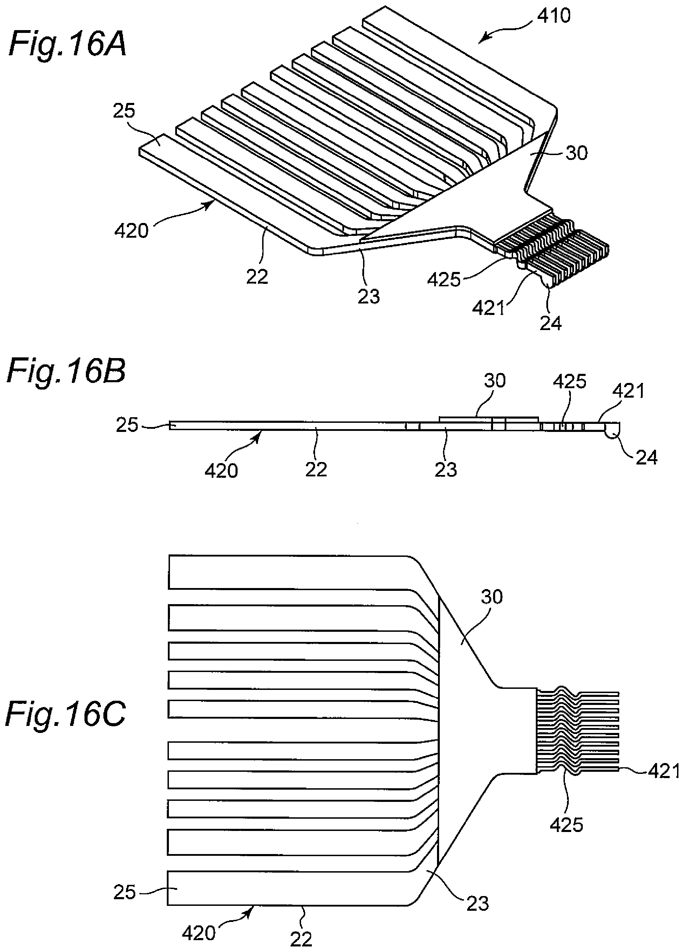

Figs. 16A, 16B, and 16C are respectively views illustrating an inspection terminal unit 410 according to a fifth embodiment of the present invention, and Fig. 16A is a perspective view of the inspection terminal unit 410, Fig. 16B is a font view of the inspection terminal unit 410, and Fig. 16C is a plan view of the inspection terminal unit 410.

In the inspection terminal unit 410 of the fifth embodiment, plural inspection pins 420 each of which includes a meandering spring unit 425 in a narrow portion 421 are integrated using the holding unit 30. The spring unit 425 is formed between the intermediate portion 23 and the contact 24 and at a position where the spring unit 425 is not covered with the holding unit 30.

The inspection pin 420 has a configuration similar to the inspection pin 20 of the first embodiment except for the narrow portion 421. For this reason, the same component as that of the first embodiment is designated by the same reference sign, and the description is omitted.

### (Sixth embodiment)

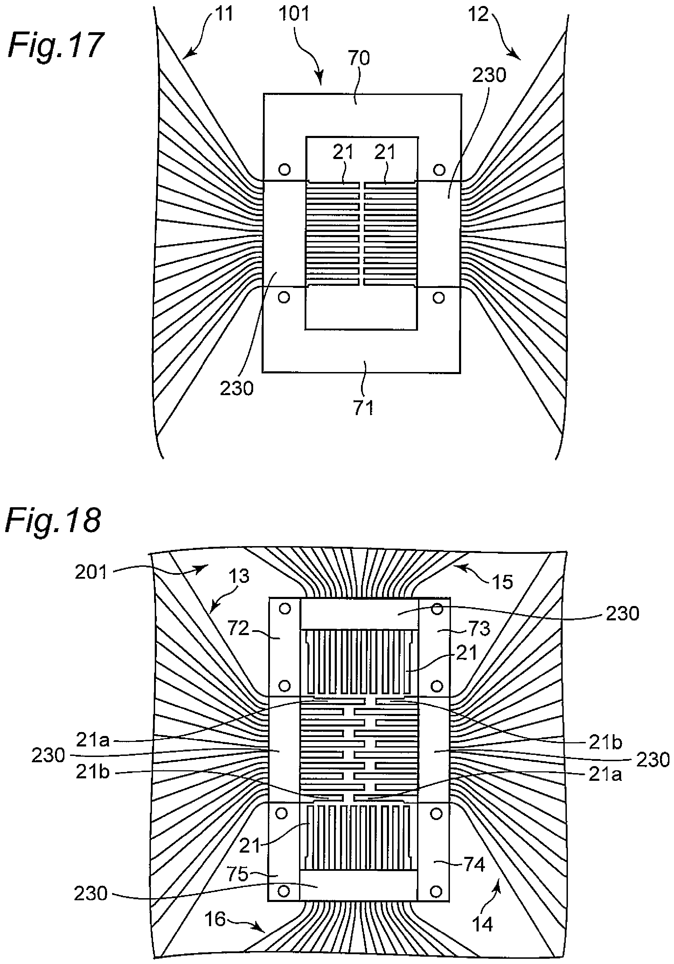

Fig. 17 is a plan view schematically illustrating a probe card 101 according to a sixth embodiment of the present invention.

The probe card 101 of the sixth embodiment includes a substrate (not illustrated), positioning members 70 and 71 mounted on the substrate, and inspection terminal units 11 and 12 positioned in the positioning members 70 and 71. In the inspection terminal units 11 and 12, the narrow portions 21 of the inspection pins 20 are integrally held by a holding unit 230.

The inspection terminal units 11 and 12 have a configuration similar to the inspection terminal unit 10 of the first embodiment except for the holding unit 230. For this reason, the same component as that of the first embodiment is designated by the same reference sign, and the description is omitted.

The inspection terminal units 11 and 12 are disposed such that the leading ends on the sides of the narrow portions 21 of the inspection pins 20 face each other, and such that the leading ends are not in contact with each other. The positioning members 70 and 71 are disposed such that both end portions of the positioning members 70 and 71 face each other with a predetermined gap. The holding units 230 of inspection terminal units 11 and 12 are disposed between the positioning members 70 and 71. For example, the holding units 230 of the inspection terminal units 11 and 12 and the positioning members 70 and 71 are bonded using a bonding adhesive to be fixed to each other.

The inspection terminal units 11 and 12 are fixed to the substrate of the probe card 101 with the positioning members 70 and 71, which allows the inspection terminal units 11 and 12 to be mounted on the substrate with high positioning accuracy. Therefore, the probe card 101 having the high positioning accuracy can be obtained.

The positioning members 70 and 71 may have any shape as long as the inspection terminal units 11 and 12 are positioned to maintain the positional relationship between the inspection terminal units 11 and 12.

### (Seventh embodiment)

Fig. 18 is a plan view schematically illustrating a probe card 201 according to a seventh embodiment of the present invention.

The probe card 201 of the seventh embodiment includes a substrate (not illustrated), four positioning members 72, 73, 74, and 75 mounted on the substrate, and four inspection terminal units 13, 14, 15, and 16 positioned in the positioning members 72, 73, 74, and 75. The same component as that of the first embodiment is designated by the same reference sign, and the description is omitted.

The inspection terminal units 13 and 14 are disposed in a zigzag manner such that each of the end portions on the side of the narrow portions 21 of the inspection pins 20 meanders, and such that the leading ends of long narrow portions 21a and the leading ends of short narrow portions 21b face each other. The inspection terminal units 15 and 16 are disposed such that the each of end portions on the side of the narrow portion 21s faces side surfaces on the sides of the narrow portions 21 of the inspection terminal units 13 and 14. The inspection terminal units 13, 14, 15, and 16 are respectively integrated using the holding units 230 provided only in the narrow portions 21. The inspection terminal units 13, 14, 15, and 16 are respectively disposed so as not to be in contact with each other.

The positioning members 72, 73, 74, and 75 are respectively disposed on the substrate (not illustrated) with a predetermined gap. The holding unit 230 of the inspection terminal unit 15 is disposed between the positioning members 72 and 73, the holding unit 230 of the inspection terminal unit 14 is disposed between the positioning members 73 and 74, the holding unit 230 of the inspection terminal unit 16 is disposed between positioning members 74 and 75, and the holding unit 230 of the inspection terminal unit 13 is disposed between the positioning members 75 and 72. For example, the holding units 230 of the inspection terminal units 13, 14, 15, and 16 and the positioning members 72, 73, 74, and 75 are bonded using a boding adhesive to be fixed to each other.

The inspection terminal units 13, 14, 15, and 16 are fixed to the substrate of the probe card 201 using the positioning members 72, 73, 74, and 75, which allows the inspection terminal units 13, 14, 15, and 16 to be mounted on the substrate with high positioning accuracy. Therefore, the probe card 201 having the high positioning accuracy can be obtained.

The constituents described in the first to seventh embodiments and the modifications may properly be combined, selected, substituted, or eliminated.

The present invention and the embodiments are summarized as follows.

The inspection terminal unit of the present invention includes:
at least two inspection pins 20 arrayed side by side each of which includes the contact portion 24 or 324 at one end (first end) of the inspection pin 20 and the connection portion 25 at the other end (second end) of the inspection pin, the contact portion being in contact with the inspection object element 2 and the connection portion 25 being connected to the substrate 3; and
the holding unit 30 that integrally holds at least the two inspection pins 20.

In the present invention, at least two inspection pins 20 arrayed side by side are integrally held using the holding unit 30. Therefore, the plural inspection pins 20 can integrally be disposed on the substrate 3, and the inspection pins 20 can be positioned with high accuracy. Resultantly, the inspection terminal unit 10 can easily be assembled to enhance the productivity of the inspection terminal unit 10.

In an embodiment of the present invention, the inspection pin 20 may be a pin formed by electroforming.

In the embodiment, the inspection terminal unit 10 can be obtained with the high positioning accuracy of the inspection pin 20.

In an embodiment of the present invention, the holding unit 30 may be a unit made of a same material as the insulating member that is used to form the inspection pin 20 by the electroforming.

In the embodiment, the insulating member used to form the inspection pin 20 is also used to form the holding unit 30, so that the number of kinds of the material to be used can be decreased. Resultantly, the productivity of the inspection terminal unit 10 can be enhanced.

In an embodiment of the present invention, the contact 24 or 324 may be provided as the contact portion at the first end of the inspection pin 20.

In the embodiment, a contact pressure between the contact portion and the inspection object element 2 can be adjusted by providing the contact 24 or 324 in the contact portion. Therefore, the inspection terminal unit 10 having high contact reliability can be obtained.

The probe cards 1, 101, and 201 of the present invention include the inspection terminal unit 10.

The present invention can provide the probe cards 1, 101, and 201 including the high-productivity inspection terminal unit 10 having the high positioning accuracy of the inspection pin 20.

In the method for manufacturing the inspection terminal unit 10 of the present invention, the method includes:
forming at least two inspection pins by the electroforming with the positional relationship, in which the inspection pins are arrayed at any pitch while separating from each other, and
integrally holding the two inspection pins by using the insulating holding unit 30 while the positional relationship is maintained.

In the present invention, the high-productivity inspection terminal unit 10 can be manufactured with the high positioning accuracy of the inspection pin 20.

### INDUSTRIAL APPLICABILITY

The inspection terminal unit of the present invention can be used in a probe card. The probe card of the present invention can also be used in a wafer inspection of semiconductor manufacturing.

### REFERENCE SIGNS LIST

1, 101, 201. probe card
2. inspection object element
3. substrate
4. connection object
10, 11, 12, 13, 14, 15, 16, 110, 210, 310, 410. inspection terminal unit
20, 120, 220, 320, 420. inspection pin
21, 221, 321, 421. narrow portion
22. wide portion
23. intermediate portion
24, 324. contact (contact portion)
25, 125. connection portion
30, 130, 230. holding unit
40. hole
50. carrier
51. breaking portion
60. projection
70, 71, 72, 73, 74, 75. positioning member
131. positioning portion
425. spring unit

## Claims

1. An inspection terminal unit **characterized by** comprising:
at least two inspection pins arrayed side by side each of which has a contact portion at a first end of the inspection pin and a connection portion at a second end of the inspection pin, the contact portion being in contact with an inspection object element and the connection portion being connected to a substrate; and
a holding unit that integrally holds at least the two inspection pins.

2. The inspection terminal unit as claimed in claim 1, **characterized in that**
the inspection pin is a pin formed by electroforming.

3. The inspection terminal unit as claimed in claim 2, **characterized in that**
the holding unit is a unit made of a same material as an insulating member that is used to form the inspection pin by the electroforming.

4. The inspection terminal unit as claimed in any one of claims 1 to 3, **characterized in that**
a contact as the contact portion is provided at the first end of the inspection pin.

5. A probe card comprising an inspection terminal unit claimed in any one of claims 1 to 4.

6. A method for manufacturing an inspection terminal unit, **characterized by** comprising:
forming at least two inspection pins by electroforming with a positional relationship, in which the inspection pins are arrayed at any pitch while separating from each other; and
integrally holding the two inspection pins by using an insulating holding unit while the positional relationship is maintained.
